Europäisches Patentamt

European Patent Office

Office européen des brevets

(19)

(11) Publication number: **0 150 623**
A2

# (12) EUROPEAN PATENT APPLICATION

(21) Application number: **84309090.3**

(22) Date of filing: **27.12.84**

(51) Int. Cl.⁴: **G 03 F 7/12**

(30) Priority: **24.01.84 GB 8401824**

(43) Date of publication of application: **07.08.85**
Bulletin 85/32

(84) Designated Contracting States: **BE CH DE FR GB IT LI NL**

(71) Applicant: **AUTOTYPE INTERNATIONAL LIMITED, Grove Road, Wantage Oxon OX12 7BZ (GB)**

(72) Inventor: **Stewart, Malcolm John, 38 Newland Mill, Witney Oxon (GB)**
Inventor: **Day, Peter, Michael George, 4 Woodgate Close, Grove Wantage Oxon (GB)**
Inventor: **Griffiths, Peter Wynne, 1 Grove Road, Wantage Oxon (GB)**

(74) Representative: **Oliver, Roy Edward et al, POLLAK MERCER & TENCH High Holborn House 52-54 High Holborn, London WC1V 6RY (GB)**

(54) **Photosensitive stencil materials.**

(57) Stencil materials for use in screen printing are multi-layer products, having a film support (1) which carries two or more light-hardenable layers (2; 3) and a peelable cover sheet (4, 5); the layer 3 in contact with the cover sheet (4, 5) has a sufficient thickness and also is sufficiently soft and tacky to be able to absorb the meshes of a printing screen at least to an extent to allow the stencil material to adhere to the screen; the layer 2 nearer the support (1) is relatively harder and non-tacky.

- 1 -

PHOTOSENSITIVE STENCIL MATERIALS

This invention relates to photosensitive stencil materials for use in screen process printing and particularly concerns precoated stencil film materials and their methods of use.

In screen printing, the printed image required is defined by a negative of the image carried upon a screen printing cloth, which is usually in the form of a woven polyester or steel fabric.  The invention provides improved methods and materials for producing screen printing stencils photographically and offers advantages both in production and use of such stencils, when compared with any of the four methods commonly used.  These known techniques can be characterized as the direct, indirect, direct/indirect and capillary methods and are described briefly below.  The invention may be termed a pressure-bonded method and is described in detail further below.

In the direct coating method, photostencils are produced by coating a light-sensitive composition, known as a direct emulsion, directly upon the stencil screen and, after drying, exposing the coated screen through a photographic positive.  The exposed photostencil is then developed by washing away the un-exposed areas in water, leaving the insoluble exposed areas in the form of a negative image which adheres firmly to the screen,

0150623

- 2 -

the mesh being encapsulated by the emulsion during the coating process. Direct emulsions are usually composed of mixtures of polyvinyl alcohol and polyvinyl acetate, post-sensitised with a dichromate salt or a water-soluble diazo resin, these emulsions cannot be supplied in a pre-sensitised form, due to shelf-life considerations. Some pre-sensitised direct emulsions based on alternative photochemistry are known, which eliminate the need to sensitise the emulsions before use. The main advantage of stencils produced by the direct coating method is their durability, while their use can also be comparatively economical, depending upon the materials and the details of the production methods employed. Their main disadvantages are inconsistency in thickness and difficulty in eliminating the mesh pattern from the edges of printed images. Unless considerable time and care are taken in the coating step, direct photostencils are unsuitable for applications where high resolution, absence of edge defects and close ink deposit control are important.

A variation of the direct coating method is also known, in which the positive is laminated to the screen with a photosensitive emulsion or lacquer during the coating operation, such as is described in GB-A-2002531. However, this method has not found wide commercial use, because of inherent disadvantages, such as contamination of photographic positives and exposure equipment by the liquid photopolymer and difficulty in removing stencils from the screen-fabric after use.

In comparison with the direct method, the other known methods for producing screen photostencils employ precoated film materials and generally provide greater consistency, better ink deposit control and higher potential image quality.

In the "indirect" method, a sub-coated transparent plastics support, usually polyester film, carries a

0150623

- 3 -

pre-sensitised polymer layer.  For instance, coatings based upon polyvinyl alcohol sensitised with a monomer/ photoinitiator are described in GB-A-1307995.  In use, a photographic positive is placed between a light source and the polyester support, so that exposure of the photosensitve coating is made through the transparent support.  The unexposed areas remain soluble in the developer, which is usually water, so that the resultant negative resist image of the original remains attached to the polyester support.  In order to prepare for printing, a moistened screen is contacted with the stencil, which is then dried and the film or other support is peeled away.

The indirect method is particularly suitable for high-resolution printing, where good definition is important and where close ink deposit control must be maintained.  However, indirect stencil materials lack durability, due to the relatively weak bond between the stencil and the screen mesh, caused by hardening of the coating before it comes into contact with the mesh.

The need for photostencil systems which combine the durability of those made by the direct method with the reproducibility and image quality of those made by the indirect method led to the development of the so-called direct-indirect stencil system, such as described in US-A-3532052.  A dry coating of a non-photo-sensitive resist layer on a support sheet is laminated with the printing surface of a screen using a photo-sensitive emulsion, which encapsulates the mesh and so firmly attaches the coating, still carried on its support, to the screen.  After drying, the support sheet is peeled away, leaving a flat even printing surface of constant and reproducible thickness on the screen.  These stencils have the advantages mentioned, but their main disadvantages are the complex processing involved in their use and the need for sensitising by the user. With most direct-indirect coated materials, the sensitiser migrates into the film material from the laminating emulsion. The amount of emulsion used for the laminating stage and the drying time are two of a number of variables governing the amount and distribution of sensitiser in the coated film. Even if procedures are carefully standardised, climatic conditions and variations in operator technique are additional factors which adversely affect the reproducibility of stencils. In the production of high-quality durable thick stencils, the direct-indirect method and materials have enjoyed considerable commercial success, even though existing materials involve tedious processing and give variable results, particularly when the slower migrating diazo-resin sensitisers are used in conjunction with coatings of more than 25µ thickness.

Capillary film materials use a presensitised dry resist coating, which is prepared by attachment to a printing screen using water, drying the coating, removing the carrier film and exposing in conjunction with a master positive. As there is no sensitising step and no need to handle chemicals or apply an emulsion coating, much of the tedious processing of the direct-indirect system is eliminated and capillary stencil methods and materials provide the best available combination of image quality, durability and reproducibility. The versatility of the capillary method is also high, as films are available in a wide range of coating thicknesses to suit a wide variety of mesh counts, and capillary materials also are available which are resistant to water-based inks, as well as those resistant to conventional solvent-based inks. At present, however, separate films must be used for these two applications.

In order to illustrate the state of the art in stencil production, the processing steps involved in the use of a capillary product, Capillex 35 (Regd. Trade Mark of Autotype International Ltd) are described below; this product is a precision-coated diazo-resin-sensitised polyvinyl alcohol/polyvinyl acetate emulsion, containing minor proportions of additives; the dry coating has a thickness of 33-36µ and its support is 75µ guage biaxially-oriented polyester film.

Preparation of Stencil attached to a Polyester Fabric Screen

(1) The screen is first thoroughly cleaned, so that the mesh fabric can hold a uniform film of water without showing signs of repellancy;

(2) The Capillex 35 film is unrolled and cut to size under "light-safe" conditions, namely in an area substantially free from ultra-violet, blue or green light; this is conveniently achieved by operating under yellow fluorescent illumination, with the elimination of sunlight;

(3) The film is rolled around a tube, with the emulsion side out, its leading edge is contacted with the top of the wet screen and the rest of the film is then unrolled across and in contact with the screen; as the emulsion is partly dissolved and sucked into the mesh by capillary action, the coating becomes firmly attached;

(4) The screen is then dried, preferably in a warm air stream, and the backing film is then peeled away;

(5) The screen is then exposed to a photographic positive in a vacuum printing frame for the required period of time (usually 2-10 mins, depending on the power and type of light source and its distance from the frame);

(6) After exposure, the stencil is washed with water to dissolve unhardened (unexposed) emulsion, leaving firmly adhered to the mesh a negative image of the photographic positive;

(7) The stencil is then dried and any open areas of mesh surrounding the image are blocked out with a screen filler;

the stencil is then ready to be mounted on a press for printing.

These seven steps just described show readily that stencil preparation even using the convenient capillary method is still relatively time-consuming and tedious, despite the fact that this method is the fastest and most reliable way at present to prepare durable high-quality printing resists. Moreover, the capillary technique, in common with direct emulsions, indirect films and direct/indirect films, does not allow the production of stencil resists which are suitable for all types of printing ink. Most stencil materials have good resistance to the organic solvents typically used in screen printing inks, e.g. aliphatic and aromatic hydrocarbons, alcohols, esters and ketones, but do not have good resistance to water-containing inks; mixtures of organic solvents and water are particularly damaging to conventional stencil materials. An exception to this is given by those photostencils which derive their solvent and water resistance from post-hardening treatments, such as baking or lacquering; these stencils are very durable but their use is normally confined to textile printing operations, as the curing operation is specialised and time-consuming and, moreover, these stencils cannot be removed from the mesh after use, giving the serious disadvantage that the expensive screen cloth cannot be re-used.

There is thus a distinct need for a new type of screen photostencil material, which is quicker, simpler and more versatile than those employed in the known methods briefly described above and which yields stencils suitable for use with solvent-based, solvent/water-based and water-based inks. It is an object of this invention to fulfil this need.

According to the present invention, a photosensitive stencil material is provided, which is in the form of a multi-layer product which is characterised by comprising a transparent plastics film support carrying at least two superposed light-hardenable layers and a cover sheet upon the light-hardenable layer furthest from the support, wherein the light-hardenable layer in contact with the cover sheet is at least sufficient in thickness to embed at least partially an applied screen printing mesh, when in use, and is more soft and tacky than the underlying light-hardenable layer nearer the film support, which is relatively harder, substantially non-deformable and non-tacky.

The substantially non-deformable and non-tacky layer serves in use to provide a flat printing surface at the interface between the stencil and the substrate to be printed and ensures that this flat surface is obtained mainly by limiting reception of the screen printing mesh to the more soft and tacky layer,which is exposed when the cover sheet is removed and the screen is brought into contact with the multilayer stencil material of the invention. This therefore provides even, i.e. uniform, reproducible ink deposits and sharply-defined printed images. It has been found that provision of the substantially non-deformable layer ensures that printed images of good quality can be obtained over a range of mesh counts. It has also been found that the products needed for an alternative system, having a single pressure-sensitive layer of a photocurable composition on a support, are difficult to store and handle, because they have a tendency toward edge seepage and coating deformation.

According to a preferred feature of the stencil material of the invention, two relatively hard substantially non-deformable and non-tacky layers are provided between the film support and the light-hardenable layer which is in contact with the cover sheet, either or both of such relatively hard, substantially non-deformable and non-tacky layers comprising a light-hardenable composition.

Preferably, the plastics film support comprises a material selected from polyesters, polyvinyl chloride, polycarbonates and polystyrene.

According to another preferred feature of the invention, the light-hardenable layer in contact with the cover sheet comprises polyvinyl pyrrolidone, pentaerythritol triacrylate, while the underlying light-hardenable layer comprises polyvinyl alcohol.

In order that the invention may be readily understood, three embodiments are described below, by way of example only, in conjunction with the accompanying drawings, in which:

Fig.1 shows diagrammatically, in section, a first embodiment of a multilayer stencil material according to the invention;

Fig. 2 shows another embodiment of the invention, again diagrammatically and in section;

Fig. 3 shows a further embodiment of the invention, also diagrammatically and in section.

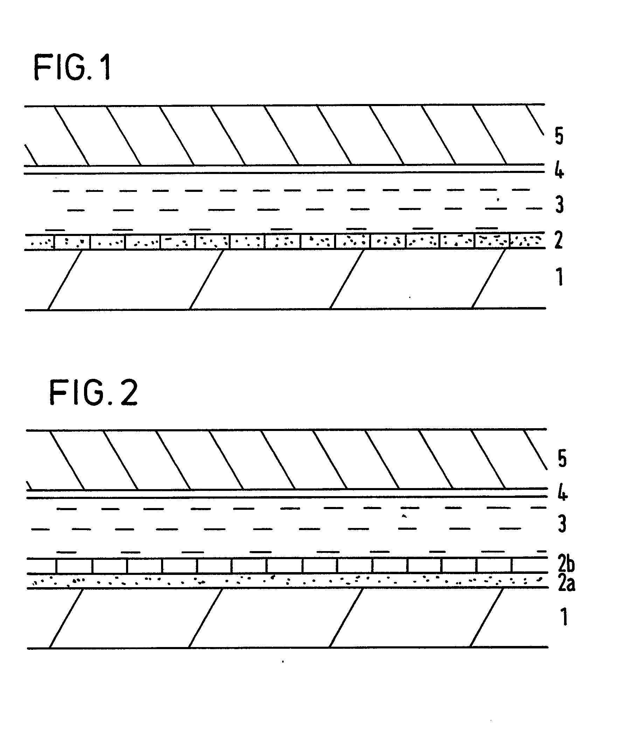

Referring to Fig.1, a transparent plastics film support 1 is coated on one side with a layer 2 of a flexible, but not easily deformable, light-hardenable composition. This layer 2 has over it a second coating layer 3, which consists of a soft relatively-deformable photo-sensitive and adhesive composition. The layer 2 is therefore also light-hardenable and additionally is relatively harder than the layer 3 and also is substantially non-deformable. In terms of their softness and tackiness, the layer 3 is more soft and more tacky than the layer 2, which is comparatively non-tacky. Finally, a release or cover sheet 4, 5 is laminated on to the otherwise exposed surface of the pressure-sensitive photocurable adhesive layer 3. This cover sheet 4,5 consists of a paper or plastics film layer 5 coated with a release layer 4, the release layer 4 being the component in contact with the adhesive layer 3. The stencil material thus comprises the support 1, the two light-hardenable layers 2 and 3 and the cover sheet 4,5.

Referring to Fig.2, this shows an embodiment in which the film support 1, the relatively soft and tacky photohardenable layer 3, the release layer 4 and the paper film layer 5, the two latter comprising the peelable cover sheet 4,5, are essentially the same as in the embodiment of Fig.1. Two separate relatively hard and non-tacky layers 2a and 2b, either or both of which may be a photocurable composition, underlie the photocurable layer 3. The layer 2a may be a photosensitive or non-photosensitive sub-coat.

The transparent plastics film support 1, in any form of the stencil material of the invention, can be any of several suitable film materials, such as polyesters, polyvinyl chloride, polycarbonates and polystyrene. The film support 1 is preferably a material which is substantially transparent to light in the wavelength band of 350-450 nm, because photo-initiators used in photohardenable layers are activated by light in this spectral region. Preferably, the transparent film support 1 has a thickness in the range from 0.2 x $10^{-1}$mm to 1.3 x $10^{-1}$mm (20-130μ). It has been found that thinner supports are usually less than satisfactory, because they often give rise to handling difficulties, while thicker supports may cause loss of resolution during exposure. The cover sheet 4,5 may be a plastics film or paper 5, treated to prevent it adhering too firmly to the pressure-sensitive photopolymerisable layer 3, by application of the release coating 4.

The thickness of the various photohardenable layers, such as the layers 2, 2a and 2b or 3 in the embodiments of Figs. 1 and 2, can be varied over wide limits. In fact, it is an advantage to vary the thickness of the layers, that is to provide a range of materials in which these layers are of different thicknesses, in order to adapt the stencils better for specific printing applications. The relatively soft adhesive photohardenable layer 3 may have its thickness regulated so as to make the resultant product more suitable for adhering to very coarse, coarse, medium, fine and very fine meshes, respectively. Generally, very coarse meshes are taken to be those having a thread count below 30 threads/cm; coarse meshes have 30-60 threads/cm; medium meshes have 60-110 threads/cm and fine meshes have 110-165 threads/cms. Any mesh having more than 165 threads/cm can be classified as very fine. Preferably, the stencil materials of the invention are made so that the light-hardenable layer in contact with the cover sheet has a thickness equal to at least half the cross-sectional thickness of a selected one of the five categories of stencil screen printing meshes represented by:

| very coarse: | $5$ to $2.5 \times 10^{-1}$ mm | (500 to 250μ) |
| coarse: | $2.5$ to $1 \times 10^{-1}$ mm | (250 to 100μ) |
| medium: | $10$ to $6 \times 10^{-2}$ mm | (100 to 60μ) |
| fine/very fine: | $8$ to $5 \times 10^{-2}$ mm | (80 to 50μ) |

whereby the stencil material can be used with screen printing meshes of the selected category and finer categories. The dimensions given for the various categories are the thread thicknesses corresponding to the respective thread counts.

In order to adhere the laminated screen stencil materials of this invention to the screen mesh, it is necessary partially to encapsulate the mesh with the soft adhesive photohardenable layer 3 of the product, which is exposed when the cover sheet 4,5 has been removed. Complete encapsulation is not necessary, but to ensure good adhesion of the stencil material to the mesh during printing, it has been found, as a general rule, that the mesh should be embedded to at least half its cross-sectional thickness,so as to ensure optimal adhesion.  It will be understood from the foregoing that it is possible to vary considerably the thickness of the soft adhesive layer 3, so as to enable the stencil material to be optimised for use with the various categories of meshes described.  Alternatively, a single product can be formulated and made, which is capable of encapsulating all classes of mesh, but, when such a product is used with medium and fine meshes, it is usually necessary to protect the vacuum blanket of the printing-down frame, during exposure, from contamination by the soft tacky photohardenable layer 3, which flows around the back of the screen threads under vacuum pressure. A further disadvantage of providing and of using one product for all categories of meshes is represented by the prolonged exposure times which are needed to photo-harden very thick adhesive layers, which is an unnecessary inconvenience if medium or fine meshes are being used. In practice, a product with a photohardenable adhesive layer of approximately 5 to 6 x $10^{-2}$mm (50-60μ) works well with medium, fine and very fine meshes; for coarser meshes the products are preferably made with adhesive layers which are progressively increased in thickness as necessary, to ensure sufficient mesh encapsulation for good stencil adhesion to be obtained.

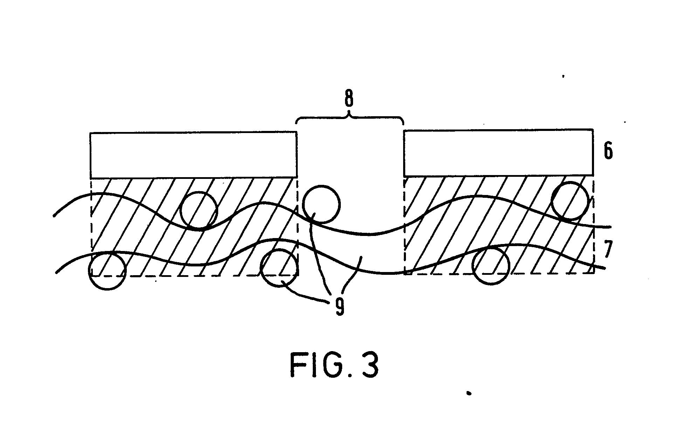

The flexible, but non-deformable layer 2, in Fig. 1, or layers 2a, 2b in Fig.2, may also have its or their thickness varied between wide limits. By varying the thickness of the photohardenable non-deformable layer 2 or 2a, 2b, the relief or height of the stencil protruding from the mesh can be varied. Since the tacky photohardenable layer 3 embeds the mesh, the flat printing surface, necessary to ensure that lateral ink flow under the stencil edges does not occur, is provided by the photohardenable non-deformable layer 2 or 2a, 2b, which sits proud of the mesh. Fig. 3 shows a schematic cross-sectional view of a monofilament screen mesh with a photohardened and developed stencil adhered to it. The layer 6 of the stencil represents the flexible non-deformable component which constitutes the printing surface and the layer 7 is the photohardened adhesive layer into which the mesh 9 is embedded. The height of the layer 6 above the mesh 9 can be varied between a few microns and several hundred microns. The thickness of the layer 6 has a direct influence on the amount of ink or other screen-printable substance deposited when the distance, 8, representing a typical stencil opening, is not greater than about 3 mm. For some screenprinting applications, it is necessary to limit the ink deposit as much as possible, in which case the thickness of the layer 6 is preferably not greater than $1 \times 10^{-2}$mm (10μ) as is normally the case in commercial half-tone colour printing. For other applications, such as the printing of solder-masks during printed circuit board manufacture, the layer 6 can advantageously be $3 - 5 \times 10^{-2}$mm (30-50μ) in thickness; in the printing of solder pastes in thick-film circuit board production, the layer 6 can advantageously be $1 - 5 \times 10^{-1}$mm (100 - 500μ) in thickness.

The laminated photosensitive multilayer stencil materials of the invention are used to prepare printing screens as follows:

A sheet of the laminated screen stencil film material of the appropriate size, which is somewhat smaller than the printing area of the screen mesh, but larger than the photographic positive to be exposed, is taken. One of its top corners is adhered to the mesh by peeling away the protective cover sheet and pressing the exposed part of the soft and tacky coating lightly into the mesh. The screen should be dry, but does not need to be specially prepared or cleaned. New (virgin) screen mesh may be used without any special pretreatment or degreasing procedure.

The protective cover sheet is then stripped away and the stencil film material is smoothed into contact with the screen mesh by hand. At this stage, the stencil film is not firmly adhered. If a printing-down frame equipped with a flexible rubber blanket is used to carry out the exposure to the photographic positive, then the pressure generated in the frame is sufficient to push the adhesive layer into the screen mesh and hence firmly adhere the stencil. If a vacuum frame is not used, then the stencil film can be adhered by ironing the stencil on to the mesh with a warm iron (50° - 120°C). If the stencil is ironed from the inside of the screen frame (squeegee side), then the release-coated cover sheet 4,5 should be placed on the mesh, so as to prevent any direct contact between the iron and the adhesive coating.

Exposure is advantageously carried out using a mercury halide, mercury vapour or carbon arc light source, the time varying with the radiation flux incident on the stencil, which in turn is a function of light intensity and distance. Exposure times similar to and faster than conventional screen stencil materials are readily obtained. After exposure, the plastics backing sheet or film support is stripped off the exposed stencil. It is possible to formulate the photohardenable coatings so that, on stripping off the backing sheet, unexposed areas of the stencil are stripped away from the screen mesh simultaneously, thereby enabling a dry-developed stencil to be provided. Alternatively, the backing sheet can be stripped away leaving all of the coating still adhered to the mesh and the unexposed areas are then washed away with water. Whichever method is preferred, the resultant stencil can be water-proof and solvent-resistant and can be used to print a wide variety of solvent-based and water-based screen inks.

The photostencil materials of the invention can be readily formulated so as not to be sensitive to normal diffuse daylight and white light from fluorescent tubes, yet can have very short exposure times using the standard light sources used with photoresist coatings. This enables screens to be prepared without the need to work in safelight conditions, which all conventional screen stencil materials require. This is a significant advantage for small printing shops which do not have sufficient space to provide segregated stencil production areas.

In summary, the screen stencil materials of the invention offer significant advantages over all of the four classes of conventional materials described above. Their ability to adhere to dry screens, without the necessity for degreasing and roughening the mesh, substantially speeds up screen make-ready times. Their ability to adhere by vacuum contact or a quick smoothing with a warm iron eliminates the tedious mounting and drying procedures required when using conventional direct, direct-indirect and capillary stencil materials. The possibility of providing self-developing materials by peeling out unexposed areas with the backing sheet is a very significant advance in ease of handling and speed of stencil production. Materials according to the invention which are developed with water can be dried simply by wiping with an absorbent cloth, due to the robust and resilient nature of the stencils produced, thus substantially eliminating the post-development drying procedure required by all the main categories of photo-stencil materials of the prior art. Moreover, the stencils produced using the invention can readily be formulated to be both water-resistant and solvent-resistant, which once again is not normally the case for conventional stencil materials.

In order that the invention may be readily understood, some practical Examples of photosensitive multi-layer stencil materials embodying the invention are described below, by way of illustration only.

In these Examples, various commercially-available materials are listed by their trade names or their registered trade marks; the lower case Roman numbers given after these product names identify the following companies:

(i)   Nippon Gohsei, Osaka, Japan

(ii)  Vinyl Products Ltd, Mill Lane, Carshalton, Surrey, England.

(iii) BASF, P O Box 4, Earl Road, Hulme, Cheadle, Cheshire, England.

(iv)  Ciba-Geigy, Paisley, Renfrewshire, Scotland.

(v)   G.A.F. (Great Britain) Co. Ltd, Tilson Road, Wythenshawe, Manchester, England.

(vi)  Industrial Minerals Corporation, Ghent, Belgium.

Example 1 describes a range of products which illustrate the effect on adhesion of a variation in thickness of the soft and tacky photohardenable layer 3, while Example 2 describes a range of products which illustrate the effect on stencil relief on the screen mesh of a variation in the thickness of the relatively hard and non-deformable layer 2.

EXAMPLE 1

| (a) Substantially non-deformable layer 2: | | % W/W |
|---|---|---|
| Polyvinyl alcohol - "Gohsenol" KH 20 (i) (80% hydrolysed) | | 3.30 |
| Polystyrene (50% aqueous dispersion)- "Vinamul" 7700 (ii) | | 4.20 |
| Polystyrene (55% aqueous dispersion)- "Vinamul" 8440 (ii) | | 8.20 |
| Acrylated polyurethane (55% aqueous dispersion) - "Laromer" PE55W (iii) | | 32.80 |
| Isopropylthioxanthone | | 0.60 |
| Ethyl-paradimethylaminobenzoate | | 2.40 |
| Water | | 47.90 |
| Aqueous dispersion of dioxazine pigment - "Unisperse" Violet BE (iv) | | 0.60 |

The polyvinyl alcohol is dissolved in the water with heating, under the action of a high shear stirrer. When a completely homogeneous solution is obtained, it is allowed to cool to 30°C and all the other ingredients are then added and slowly stirred in, until the mix is again completely homogeneous.

| (b) Substantially soft and tacky layer 3: | | % W/W |
|---|---|---|
| Polyvinyl pyrrolidone - K90 | (v) | 5.50 |
| Pentaerythritol triacrylate | | 42.00 |
| Industrial methylated spirit (IMS) | | 36.40 |
| Diethoxyacetophenone - "Irgacure" 651 | (iv) | 0.15 |
| Talc - "Mistron Monomix" | (vi) | 15.80 |
| Triethanolamine | | 0.15 |

The pentaerythritol triacrylate, "Mistron Monomix" and the polyvinyl pyrrolidone are added to the IMS and these ingredients are mixed using a high shear stirrer until fully homogeneous. The mix is then allowed to cool to 30°C. The other ingredients are then added and the mix is slowly stirred until it is again completely homogeneous.

A coating of component (a) followed by a coating of component (b) were applied, using wire wound rods (see Table 1, to a transparent film support, such as that shown at 1 in Fig.1, comprising a $5 \times 10^{-2}$ mm thick "Melinex" polyester film (I.C.I.) Drying of the coating was carried out using 40°C warm air.

The resultant series of coated films were then laminated to 72 g/m$^2$ kraft paper polythene-coated on one side and silicone-treated on the polythene side, serving as the release-coated cover sheet (4/5 in Figs. 1 and 2).

The range of stencil film materials so manufactured were then used, by being applied to screen printing meshes by the technique described above, by peeling away the silicone-coated release backing paper (4/5) and applying the exposed soft and tacky layer (3) to the mesh fabric. With the aid of smooth hard pressure, the film materials were adhered by thus causing the layers (3) to penetrate the mesh.

Photographic exposure of the films was accomplished using a 3 kW "Nu-Arc" Fliptop unit with a mercury halide lamp. A vacuum frame held the photographic positive in contact with the polyester support (1). The siliconised backing sheet (4/5) removed in applying the films to the screens can be used to prevent any tackiness at the back of the mesh from spoiling the vacuum blanket.

After exposure, the screen is removed from the exposure unit and the backing sheet (4/5) is removed if still adhering. The polyester support (1) is peeled away from the surface of the film and the film is washed thoroughly with cold or warm water, until all unexposed areas of the stencil film are removed. The finished stencil film may then be dried with either a warm fan or by wiping with a cloth prior to use.

| | 40 | 73 | 90 | 120 |
|---|---|---|---|---|
| Mesh Size (Threads/cm) | 40 | 73 | 90 | 120 |
| Thickness of Layer 2 ($10^{-3}$ mm) | 9  8  9 | 8  9  9 | 9  10  9 | 9  9  8 |
| Wire Wound Rod mm ($10^{-3}$ in) | 0.63 (25) | 0.63 (25) | 0.63 (25) | 0.63 (25) |
| Thickness of Layer 3 ($10^{-3}$ mm) | 61  72  87 | 25  49  73 | 17  35  41 | 6  19  25 |
| Wire Wound Rod mm ($10^{-3}$ in) | 1.52  1.77  2.03 (60) (70) (80) | 0.76  1.14  1.77 (30) (45) (70) | 0.50  0.89  1.02 (20) (35) (40) | 0.25  0.50  0.76 (10) (20) (30) |
| Stencil Relief ($10^{-3}$ mm) | 9.2  16.6  30.6 | 11.7  15.0  33.8 | 10.8  12.4  17.5 | 9.2  13.2  15.6 |
| Film Penetration into Mesh (%) | 90  100  100 | 50  100  100 | 50  100  100 | 75  100  100 |
| Thickness of layer 3 to enclose mesh | 65 | 45 | 33 | 14 |
| **Performance**<br><br>Rub resistance to 50/50 cyclohexanone/ 2-ethoxyethanol and 80/20 water/2-butoxyethanol. | All films very hard and resistant to solvents and solvent/water blends. | Stencil with 25 x $10^{-3}$ mm of layer (3) washed off mesh, other all very hard and resistant to solvents and solvent/water blends. | Stencil with 17 x $10^{-3}$ mm of layer (3) washed off mesh, others all very hard and resistant to solvents and solvent water blends. | Stencil with 6 x $10^{-3}$ mm of layer (3) gave poor solvent/water resistance and was easily damaged, others performed well. |

Table 1 shows that the meshes which were completely enclosed were well adhered and showed a rugged nature in use and were extremely resistant to soaking and subsequent rubbing with the solvents and solvent/water blends commonly used in screen inks, i.e. cyclohexanone, 2-ethoxyethanol and 2-butoxyethanol.

Where the meshes were not totally encapsulated with the stencil film layer (3), adhesion to the mesh suffered, resulting in stencil damage, this effect becoming more pronounced as the mesh encapsulation decreased.

EXAMPLE 2

The formulations of the non-deformable and tacky layers (2) and (3) were as in Example 2.

Table 2 shows the effect of a variation in the thickness of the layer (2) in the film material, when applied to a 40 threads/cm polyester mesh. Coating, drying, laminating, exposure and water wash-out of the stencil films were carried out as in Example 1.

TABLE 2

| THICKNESS ($\times 10^{-3}$ mm) | | STENCIL HEIGHT ABOVE MESH | EXPOSURE UNITS | ASSESSMENT OF PENETRATION INTO MESH |
|---|---|---|---|---|
| LAYER 2 | LAYER 3 | | | |
| – | 45 | 5.0 | 30 | 80% |
| 3 | 36 | 7.7 | 30 | 60% |
| 10 | 35 | 13.6 | 30 | 60% |
| 14 | 35 | 17.0 | 30 | 60% |
| 24 | 35 | 23.0 | 45 | 60% |

From Example 1 it can be seen that approximately $65 \times 10^{-3}$ mm of film thickness (3) was required to enclose fully the 40 threads/cm mesh. A considerably reduced thickness of layer (3) was purposely chosen, in order to illustrate the effect upon stencil relief of a variation in the thickness of layer (2).

Table 2 clearly shows the comparable stencil relief obtained for a given thickness of layer (2) and the use of this layer for controlling the stencil relief.

CLAIMS

1. A photosensitive stencil material, in the form of a multi-layer product, characterised by comprising a transparent plastics film support carrying at least two superposed light-hardenable layers and a cover sheet upon the light hardenable layer furthest from the support, wherein the light-hardenable layer in contact with the cover sheet is sufficient in thickness to embed at least partially an applied screen printing mesh, when in use, and is more soft and tacky than the underlying light-hardenable layer nearer the film support, which is relatively harder, substantially non-deformable and non-tacky.

2. A stencil material according to claim 1, wherein two relatively hard substantially non-deformable and non-tacky layers are provided between the film support and the light-hardenable layer which is in contact with the cover sheet, either or both of such relatively hard, substantially non-deformable and non-tacky layers comprising a light-hardenable composition.

3. A stencil material according to claim 1 or 2, wherein the light-hardenable layer in contact with the cover sheet has a thickness equal to at least half the cross-sectional thickness of a selected one of the five categories of stencil screen printing meshes represented by:

| very coarse: | $5$ to $2.5 \times 10^{-1}$ mm | (500 to 250μ) |
|---|---|---|
| coarse: | $2.5$ to $1 \times 10^{-1}$ mm | (250 to 100μ) |
| medium: | $10$ to $6 \times 10^{-2}$ mm | (100 to 60μ) |
| fine/very fine: | $8$ to $5 \times 10^{-2}$ mm | (80 to 50μ) |

whereby the stencil material can be used with screen printing meshes of the selected category and finer categories.

4. A stencil material according to any preceding claim, wherein the plastics film support comprises a material selected from polyesters, polyvinyl chloride, polycarbonates and polystyrene.

5. A stencil material according to any preceding claim, wherein the plastics film support is substantially transparent to light in the wavelength range from 350 to 450 nm.

6. A stencil material according to any preceding claim, wherein the plastics film support has a thickness in the range from 0.2 to $1.3 \times 10^{-1}$ mm (20 to 130$\mu$).

7. A stencil material according to any preceding claim, wherein the light-hardenable layer in contact with the cover sheet comprises polyvinyl pyrrolidone, pentaerythritol triacrylate, while the underlying light-hardenable layer comprises polyvinyl alcohol.

FIG.1

5
4
3
2
1

FIG.2

5
4
3
2b
2a
1

FIG. 3